# EUROPEAN PATENT SPECIFICATION

(11) **EP 4 096 051 B1**
(45) Date of publication and mention of the grant of the patent: **18.11.2026**
(21) Application number: 21207268.0
(22) Date of filing: 09.11.2021
(51) Int. Cl.: H02J 7/65

(54) **CHARGING CIRCUIT, CHARGING CONTROL METHOD AND ELECTRONIC DEVICE**
LADESCHALTUNG, LADESTEUERUNGSVERFAHREN UND ELEKTRONISCHE VORRICHTUNG
CIRCUIT DE CHARGE, PROCÉDÉ DE COMMANDE DE CHARGE ET DISPOSITIF ÉLECTRONIQUE

(30) Priority: 26.05.2021 CN 202110578704
(43) Date of publication of application: 30.11.2022
(73) Proprietor: Beijing Xiaomi Mobile Software Co., Ltd., Beijing 100085 (CN)
(72) Inventor: LIANG, Lei, Beijing, 100085 (CN)
(74) Representative: Dehns Germany Partnerschaft mbB

(56) References cited:
- CN-A- 112 104 243
- US-A1- 2018 034 305
- US-A1- 2018 041 060
- US-A1- 2021 036 533
- US-A1- 2021 119 487
- US-B1- 8 907 631

## Description

### TECHNICAL FIELD

The present disclosure relates to a field of electronic device technologies, and more particularly, to a charging control method and an electronic device.

### BACKGROUND

With increasing requirements for greater charging power of electronic devices such as mobile phones, an electronic device may use two or more charging chips. The use of two or more charging chips may improve charging power and minimize increasing temperature while charging. Many different layouts and connection modes between multiple charging chips are possible, and these configurations may have a large impact on a charging strategy and performance.

A current solution of two or more charging chips charging together adopts a master-slave mode. Only one of the two or more charging chips is designated as a master chip, and the other chips are designated as slave chips. The master chip sends a synchronous clock signal to the slave chips to drive the slave chips to operate. In master-slave mode, when it is required to turn off one charging chip alone, only the slave chip is turned off. This situation makes adjustments of the charging strategy unable to adapt to all scenarios, which will not realize optimization of charging, and will reduce charging efficiency.

US2021/036533A1 discloses a multi-port battery charge and discharge system used in the charge and discharge battery pack application.

Further relevant prior art is known from CN112104243A, US2021/119487A1, US8907632B1 and US2018/034305A1. Background prior art is known from US2018/041060A1.

### SUMMARY

In order to overcome at least part of problems in the related art, the present disclosure provides an electronic device comprising the features of claim 1 and a charging control method comprising the features of claim 9. Advantageous embodiments are the subject matter of the dependent claims..

**In** a first aspect, the present disclosure provides an electronic device. The electronic device includes a battery and at least two charging chips for charging the battery. Each of the at least two charging chips is configured to operate in an independent charging mode. Each charging chip includes a first voltage sampling end and a second voltage sampling end for collecting voltage information of the battery, and each charging chip is configured for independent charging according to the collected voltage information. The first voltage sampling end and the second voltage sampling end are respectively connected to two poles of the battery. The electronic device further includes a controller, configured to, determine an operating state of the electronic device, and in a case that an operating state of the electronic device is in a screen-off state, adjust the at least two charging chips to a first charging mode, and respectively control the at least two charging chips to operate.

Advantageously, the electronic device includes:
a mainboard, in which the respective charging chips are provided on the main board; or
at least two mainboards, in which the respective charging chips are provided on a same mainboard in the at least two mainboards; or
at least two mainboards, in which each mainboard is provided with at least one charging chip.

In some embodiments, the electronic device includes two charging chips and two mainboards including a large board and a small board, the large board is provided with one of the two charging chips, and the small board is provided with the other one of the two charging chips.

Advantageously, the electronic device includes a controller, and further includes at least two mainboards, and each mainboard is provided with at least one charging chip. The controller is configured to obtain temperatures of the at least two mainboards respectively, and control operation or turn-off of the charging chips provided on the at least two mainboards according to the temperatures of the at least two mainboards.

Advantageously, the electronic device includes a controller, and further includes a mainboard, in which the at least two charging chips are respectively provided in different areas of the mainboard. The controller is configured to obtain temperatures of the different areas of the mainboard respectively, and control operation or turn-off of the charging chips provided in the different areas according to the temperatures of the different areas of the mainboard.

Advantageously, the electronic device includes a controller. The controller is configured to, determine at least one of an operating state of the electronic device and a running state of an application running on the electronic device, adjust a charging mode of each of the at least two charging chips according to at least one of the operating state of the electronic device and the running state of the application running on the electronic device, and control the operation or turn-off of each charging chip.

Advantageously, each charging chip includes a voltage input wire and a voltage output wire, the voltage input wire is configured for connecting with an external power supply, and the voltage output wire is configured for connecting with the battery. Each charging chip includes a first switch tube and at least one charging path, each charging path is provided with a capacitor, and each charging path is formed by a plurality of switch tubes connected in series. A first end of each charging path is connected to a first end of the first switch tube, and a second end of each charging path is grounded. The voltage input wire is connected to a second end of the first switch tube; the voltage output wire is connected to between any two switch tubes of each charging path.

Advantageously, the at least one charging path includes a first charging path and a second charging path, the first charging path is provided with a first capacitor, and the second charging path is provided with a second capacitor. The first charging path includes a second switch tube, a third switch tube, a fourth switch tube and a fifth switch tube connected in series successively, and the second charging path includes a sixth switch tube, a seventh switch tube, an eighth switch tube and a ninth switch tube connected in series successively. A first end of the first capacitor is connected between the second switch tube and the third switch tube, and a second end of the first capacitor is connected between the fourth switch tube and the fifth switch tube. A first end of the second capacitor is connected between the sixth switch tube and the seventh switch tube, and a second end of the second capacitor is connected between the eighth switch tube and the ninth switch tube. The voltage output wire is connected between the third switch tube and the fourth switch tube and between the seventh switch tube and the eighth switch tube.

In a second aspect, the present disclosure provides a charging control method, applicable for an electronic device including a battery and at least two charging chips for charging the battery, wherein each of the at least two charging chips is configured to operate in an independent charging mode. The control method includes: determining at least one of an operating state of the electronic device and a running state of an application running on the electronic device; adjusting a charging mode of each of at least two charging chips according to at least one of the operating state of the electronic device and the running state of the application running on the electronic device, and controlling the operation or turn-off of each charging chip. Adjusting the charging mode of each of the at least two charging chips according to at least one of the operating state of the electronic device and the running state of the application running on the electronic device, and control the operation or turn-off of each charging chip includes: in a case that the operating state of the electronic device is in a screen-off state, adjusting the at least two charging chips to a first charging mode, and respectively controlling the at least two charging chips to operate.

Advantageously, adjusting the charging mode of each of the at least two charging chips according to the operating state of the electronic device and/or the running state of the application running on the electronic device, and control the operation or turn-off of each charging chip includes:
in a case that the operating state of the electronic device is that a brightness of a screen is less than a preset value, and a preset application is running, adjusting the at least two charging chips to a second charging mode, and respectively controlling the at least two charging chips to operate, in which a charging current of the second charging mode is less than a maximum charging current of the first charging mode;
in a case that the operating state of the electronic device is that the brightness of the screen is not less than the preset value, and the preset application is running, adjusting the at least two charging chips to the first charging mode, control a charging chip associated with the preset application to turn off, and other charging chips other than the charging chip associated with the preset application to operate.

Advantageously, the control method includes:
collecting voltage information of the battery by a first voltage sampling end and a second voltage sampling end of each charging chip;
performing, by each charging chip, independent charging, according to the collected voltage information, wherein the first voltage sampling end and the second voltage sampling end are respectively connected to two poles of the battery.

Advantageously, the electronic device includes at least two mainboards, each mainboard is provided with at least one charging chip. And the control method includes:
obtaining temperatures of the at least two mainboards respectively;
controlling operation or turn-off of the charging chips provided on the at least two mainboards according to the temperatures of the at least two mainboards.

Advantageously, the electronic device comprises a mainboard, the at least two charging chips are respectively provided in different areas of the mainboard. And the control method includes:
obtaining temperatures of the different areas of the mainboard respectively;
controlling operation or turn-off of the charging chips provided in the different areas according to the temperatures of the different areas of the mainboard.

The technical solution according to the embodiments of the present disclosure may include the following beneficial effects.

Each charging chip is configured to operate in the independent charging mode, and the voltage information of the battery may be collected independently through the first voltage sampling end and the second voltage sampling end, and charging chips may perform independent charging according to the collected voltage information without affecting each other. Any charging chip may be flexibly turned off according to different scenarios, and more charging scenarios may be applied.

It should be understood that the above general description and the following detailed description are only exemplary and explanatory.

### BRIEF DESCRIPTION OF THE DRAWINGS

FIG. 1 is a schematic diagram of a charging circuit according to an embodiment of the present disclosure.
FIG. 2 is a block diagram of an electronic device according to an embodiment of the present disclosure.
FIG. 3 is a flowchart of a method of charging the electronic device of FIG. 2 according to an embodiment of the present disclosure.
FIG. 4 is a block diagram of an electronic device according to another embodiment of the present disclosure.
FIG. 5 is a flowchart of a charging control method according to an embodiment of the present disclosure.

### DETAILED DESCRIPTION

The present disclosure will be described in detail below in combination with embodiments shown in the accompanying drawings. However, these embodiments do not limit the present disclosure, and the structural, method, or functional changes made by those skilled in the art according to these embodiments are included in the scope of protection of the present disclosure.

Terms used in the present disclosure are merely for a purpose of describing specific embodiments, but are not to limit the present disclosure. The singular forms "a," and "the" in the description and claims of the present disclosure are also intended to include the majority form unless the context clearly indicates other meanings. It should also be understood that the term "and/or" used herein refers to and includes any or all possible combinations of one or more associated listed items.

A charging circuit, a charging control method and an electronic device of the present disclosure are described in detail below in combination with the accompanying drawings. Without conflict, features in the following embodiments and implements may be combined with each other.

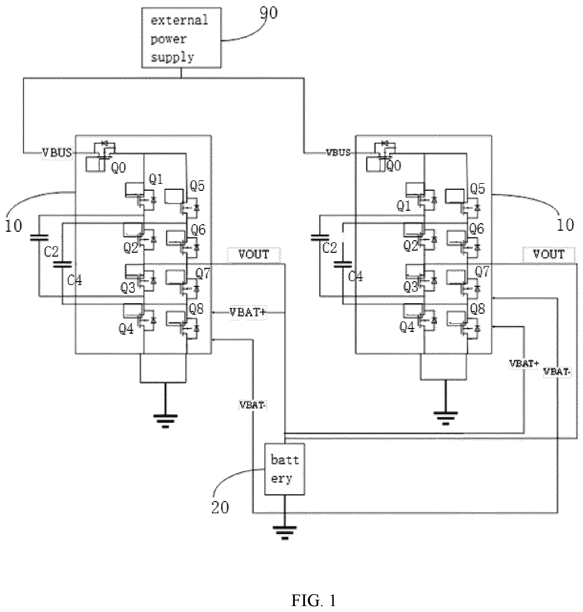

Referring to FIG. 1, embodiments of the present disclosure provide a charging circuit. The charging circuit includes at least two charging chips 10 for charging a battery of an electronic device. The charging chip 10 may be understood as a charge pump. Each of the at least two charging chips 10 is configured to operate in an independent charging mode. "Multiple" or "a plurality of" described in the present disclosure refers to two or more. In some embodiments, the number of the charging chips 10 may be two. The accompanying drawings take two charging chips 10 as an example.

In the present disclosure, each charging chip 10 may be configured to operate in the independent charging mode based on the charging circuit including respective charging chips 10. For example, when the electronic device is powered on, a CPU may configure each charging chip 10 to operate in the independent charging mode, and then each charging chip 10 may collect voltage information and preform charging independently.

Each charging chip 10 includes a first voltage sampling end VBAT+ and a second voltage sampling end VBAT- for collecting voltage information of the battery 20, and each charging chip 10 is configured for independent charging according to the collected voltage information. The first voltage sampling end VBAT+ and the second voltage sampling end VBAT- are respectively connected to two poles of the battery 20.

In the charging circuit of FIG. 1, each charging chip 10 is configured to operate in the independent charging mode, which may independently collect the voltage information of the battery 20 through the first voltage sampling end VBAT+ and the second voltage sampling end VBAT-, and each charging chip 10 may operate independently according to the collected voltage information without affecting each other. Any charging chip 10 may be flexibly turned off according to different scenarios, and more charging scenarios may be applied. For example, taking two charging chips as an example, when the electronic device is powered on, the CPU of the electronic device configures both of the two charging chips to operate in the independent charging mode, and then the two charging chips may collect voltage information for independent charging. The two do not affect each other, rather than a master-slave mode. Therefore, the electronic device may selectively turn off any charging chip according to different operation modes or a heating condition of the whole machine, which may meet more different charging scenarios.

In some embodiments, each charging chip 10 includes a voltage input wire VBUS and a voltage output wire VOUT, the voltage input wire VBUS is configured for connecting with an external power supply 90, and the voltage output wire VOUT is configured for connecting with the battery 20. Each charging chip 10 includes a first switch tube Q0 and at least one charging path, each charging path is provided with a capacitor, which may be a capacitor for charging or discharging. Each charging path is formed by a plurality of switch tubes connected in series. A first end of each charging path is connected to a first end (a right end shown in the figure) of the first switch tube Q0, and a second end of each charging path is grounded. The voltage input wire VBUS is connected to a second end (a left end shown in the figure) of the first switch tube Q0, and the voltage output wire VOUT is connected to a node formed between any two switch tubes of each charging path. With the above settings, the external power supply may charge the capacitor through the charging path. After the capacitor is fully charged, the battery 20 may be charged by the capacitor as standby power without connecting with the external power supply, so as to prolong a standby time of the electronic device.

In the example shown in the figure, at least one charging path, taking two as examples, may include a first charging path and a second charging path. The first charging path is provided with a first capacitor C2 and the second charging path is provided with a second capacitor C4. The first charging path includes a second switch tube Q1, a third switch tube Q2, a fourth switch tube Q3 and a fifth switch tube Q4 connected in series successively, and the second charging path includes a sixth switch tube Q5, a seventh switch tube Q6, an eighth switch tube Q7 and a ninth switch Q8 tube connected in series successively.

A first end (an upper end shown in the figure) of the first capacitor C2 is connected to a node formed between the second switch tube Q1 and the third switch tube Q2, and a second end (a lower end shown in the figure) of the first capacitor C2 is connected to a node formed between the fourth switch tube Q3 and the fifth switch tube Q4. A first end (an upper end shown in the figure) of the second capacitor C4 is connected to a node formed between the sixth switch tube Q5 and the seventh switch tube Q6, and a second end (a lower end shown in the figure) of the second capacitor C4 is connected to a node formed between the eighth switch tube Q7 and the ninth switch tube Q8. The voltage output wire VOUT is connected to a node formed between the third switch tube Q2 and the fourth switch tube Q3 and a node formed between the seventh switch tube Q6 and the eighth switch tube Q7.

With the above setting, the external power supply may charge the first capacitor C2 via the first charging wire and charge the second capacitor C4 through the second charging wire. After the first capacitor C2 and the second capacitor C4 both are fully charged, the battery 20 may be charged by the first capacitor C2 and the second capacitor C4 as standby powers without external power supply, which may prolong the standby time of the electronic device.

Continuing to refer to FIG. 1, embodiments of the present disclosure also provide an electronic device, which may be a mobile terminal such as a mobile phone, a tablet, etc. The electronic device may include a battery 20 and a charging circuit. It should be noted that the description of the charging circuit in the above embodiments and implements is also applicable for the electronic device of the present embodiment. A positive pole of the battery 20 is connected to the voltage output wire VOUT of the charging chips 10 of the charging circuit, and a negative pole of the battery 20 is grounded.

In the charging circuit, each charging chip 10 is configured to operate in an independent charging mode, which may independently connect with the external power supply 90 and the battery 20, and independently collect the voltage information of the battery 20 through the first voltage sampling end VBAT+ and the second voltage sampling end VBAT-. Each charging chip 10 may operate independently according to the collected voltage information without affecting each other. The electronic device may flexibly turn off any charging chip 10 according to different scenarios, and more charging scenarios may be applied. For example, taking two charging chips as an example, when the electronic device is powered on, the CPU of the electronic device configures both of the two charging chips to operate in the independent charging mode, and then the two charging chips may respectively collect voltage information for independent charging. The two charging chips do not affect each other. Therefore, the electronic device may selectively turn off any charging chip according to different operation modes or the heating condition of the whole machine, which may meet more different charging scenarios.

In some embodiments, the electronic device may include at least one mainboard. When the electronic device includes one mainboard, the respective charging chips 10 are provided on the mainboard.

When the electronic device includes at least two mainboards, the respective charging chips 10 may be provided on a same mainboard in the at least two mainboards. Taking two mainboards including a large board and a small board as an example, the respective charging chips may be provided on the large board. Both charging chips are provided on the same mainboard. In this way, it is easier to control charging current through wiring impedance.

When the electronic device includes at least two mainboards, each mainboard is provided with at least one charging chip 10. Taking two mainboards and two charging chips as an example, the two mainboards include the large board and the small board, and the large board is provided with one charging chip, and the small board is provided with the other charging chip.

Such layout leads to dispersion of heat sources, which is easy to improve charging performances, and corresponding settings are made on the wiring impedance, so as to achieve a balance of current distribution between the two charging chips.

Because each charging chip is arranged independently, a position of each charging chip may be flexibly set according to an actual number and layout of the mainboard. And each charging chip may independently detect the voltage information of the battery for charging. In a case that it is not required such a large charging current, any charging chip may be turned off, or the charging chip in the area with a high temperature is turned off according to the heating condition of the mainboard. In this way, the position of the charging chip may be flexibly arranged, and the layout of the mainboard may also be flexibly adjusted and have diversity.

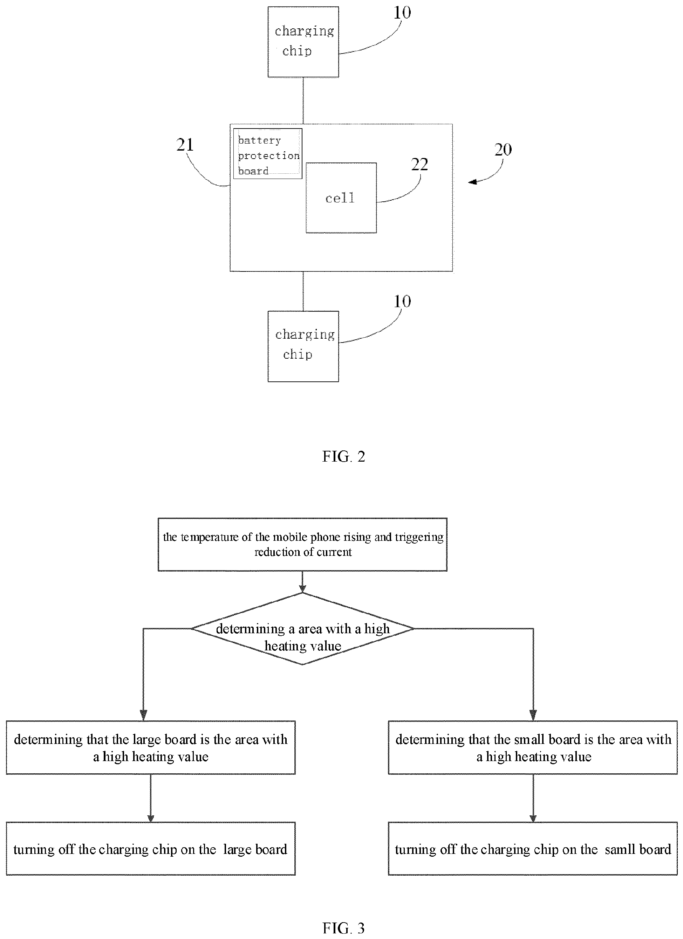

As illustrated in FIG. 2, in some embodiments, the battery 20 includes a battery protection board 21 and a cell 22 provided on the battery protection board 21, and the battery protection board 21 is provided with connecting wires for connecting with the voltage output wires VOUT. The voltage output wires VOUT of the charging chips 10 are connected to the battery protection board 21 through the connecting wires, so as to charge the cell 22. In FIG. 2, there are two mainboards, including a large board and a small board, for example, the large board is located on one side of the battery, and the small board is located on the other side of the battery. And each of the large board and the small board is provided with one charging chip, so the two charging chips 10 are respectively located on the upper and lower sides of the battery protection board 21. Since the charging chips 10 of the present disclosure are independently arranged, the positions of the two charging chips 10 may be arranged according to the position of the mainboards, which may make the layout of the mainboards more flexible, or may be arranged according to the actual requirements, which will not be limited in the present disclosure.

As illustrated in FIG. 3, each of the large board and the small board is provided with a charging chip. For the electronic device, taking the mobile phone as an example, both the large board and the small board have heat sources. When the temperature of the mobile phone rises, the charging control may trigger reduction of current. For example, in a case that the heat source of the large board is the CPU, and a corresponding scene is, such as, charging while playing games, the temperature of the large board will rise and the large board will be hotter than the small board. At this time, the charging chip provided on the large board may be turned off and the charging chip provided on the small board may operate. In this way, the heat balance of the whole machine may be realized, a charging speed may be maximized and the heating value of the whole machine may be reduced. For another example, the heat source of the small board usually lies in backlight of a LCD screen and other heating devices on the small board. When the screen of the electronic device is at a maximum brightness, the temperature of the small board will rise and the small board will be hotter than the large board. At this time, the charging chip provided on the small board may be turned off and the charging chip of the large board may operate.

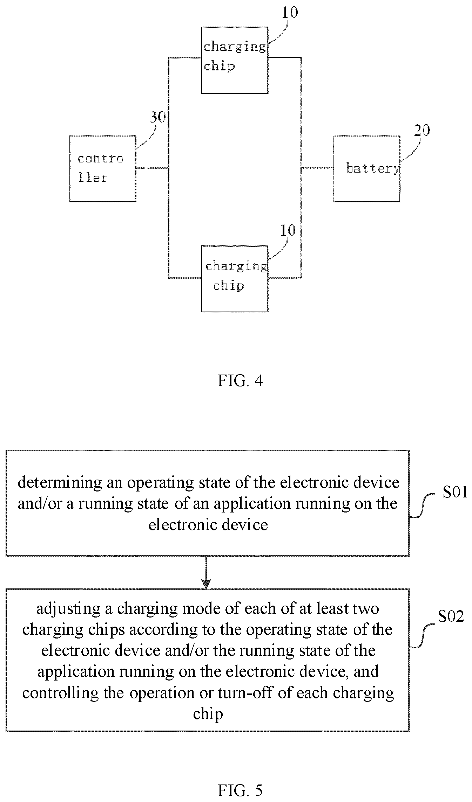

Referring to FIG. 4, in some embodiments, the electronic device may also include a controller 30 connected with the plurality of charging chips 10. The controller 30 is configured to control operation or turn-off of the charging chips 10. The controller 30 may be provided on the mainboard, and may determine the charging chip 10 located at which positions to turn off according to the heating condition of the mainboard or the heating condition of the whole electronic device. Alternatively, the controller 30 may be a CPU of an electronic device. The controller 30 may independently collect the voltage information of the battery 20 according to the first voltage sampling end VBAT+ and the second voltage sampling end VBAT- of each charging chip 10, and determine whether to control multiple charging chips 10 to charge the battery simultaneously, or control a part of the charging chips 10 to charge the battery.

**In** some embodiments, when the electronic device includes one mainboard and the plurality of charging chips 10 are provided in different areas of the mainboard, the controller is configured to obtain temperatures of the different areas of the mainboard respectively, and control the operation or turn-off of the charging chips provided in different areas according to the temperatures of the different areas of the mainboard, That is, the controller 30 selectively turns off the charging chip 10 provided in the corresponding area according to the heating conditions of the different areas of the mainboard. For example, the mainboard is provided with a plurality of detection resistors, and the plurality of detection resistors are arranged in different areas of the mainboard. The controller 30 may determine the heating of the different areas of the mainboard according to a resistance value of each resistance, so as to control the charging chip 10 in the corresponding area to turn off.

In some embodiments, in a case that the electronic device includes the at least two mainboards and each mainboard is provided with at least one charging chip 10, the controller is configured to obtain temperatures of the at least two mainboards respectively, and control the operation or turn-off of the charging chips provided on the at least two mainboards according to the temperatures of the at least two mainboards. That is, the controller 30 may selectively turn off the charging chip 10 provided on the mainboard with large heating according to the heating condition of each mainboard. For example, each mainboard is provided with a detection resistor, and the controller 30 may determine the heating condition of each mainboard according to the resistance value of the detection resistor, so as to control the charging chip 10 on the corresponding mainboard to turn off.

For example, each of the large board and the small board are provided with one charging chip, and the electronic device takes the mobile phone as an example. Both the large board and the small board have heat sources. When the temperature of the mobile phone rises, the charging may trigger reduction of current. In the case that the heat source of the large board is the CPU and the corresponding scene is charging while playing games, the temperature of the large board will rise, and the large board will be hotter than the small board. At this time, the controller 30 detects a change of the resistance value of the detection resistor on the large board, determines that the temperature the large board rises, and then control the charging chip provided on the large board to turn off and make the charging chip of the small board continue to work, so as to realize the heat balance of the whole machine, and reduce the heating of the whole machine. The heat source of the small board lies in the backlight of the LCD screen and other heating devices at the position of the small board. When a user turns the screen to the maximum brightness, the temperature of the small board will rise, and the small board will be hotter than the large board. At this time, the controller 30 detects a change of the resistance value of the detection resistor on the small board, and determines that the temperature of the small board rises, and then controls the charging chip on the small board to turn off and make the charging chip of the large board continue to operate, so as to realize the heat balance of the whole machine and reduce the heating of the whole machine.

In addition, in some embodiments, the operation or turn off of the charging chip provided on each mainboard may also be controlled according to the temperature of each mainboard and a preset temperature threshold.

In some embodiments, the electronic device may have a variety of different operating states, and running states of different applications in the electronic device may also be different. The controller may also be configured to determine the operating state of the electronic device and/or the running state of the application running on the electronic device, adjust the charging mode of the at least two charging chips according to the operating state of the electronic device and/or the running state of the application running on the electronic device, and control the operation or turn-off of the at least two charging chips respectively. The heating values of the mainboard of the electronic device are different due to different operating states or running states of the applications. Through the above settings, the charging chip provided on the mainboard with large heating may be turned off more accurately, and the temperature while charging may be controlled to adapt to different application scenarios, so as to reduce the heating of the whole machine and make the whole machine heat balanced.

Taking the electronic device including a large board and a small board, each of which is provided with a charging chip as an example, different applications will have a corresponding relationship with the large board or small board. The controller may control the charging chip on the associated large board or small board to turn off according to the large board or small board associated with different applications.

For example, because the large board is provided with heating elements such as CPU, the temperature of the large board will rise when users charging the electronic device while playing games, and the large board will be hotter than the small board. The controller detects that the temperature of the large board rises, so as to control the charging chip on the large board to turn off and let the charging chip on the small board continue to operate, so as to make the heat balance of the whole machine and reduce the heating of the whole machine. Because the small board is provided with LCD and other heating devices, when the user turns on the screen to the maximum brightness, the temperature of the small board will rise, and the small board will be hotter than the large board. The controller detects that the temperature of the small board is rise, and then control the charging chip on the small board to turn off and let the charging chip on the large board continue to operate, so as to realize the heat balance of the whole machine and reduce the heating of the whole machine.

For example, the charging mode of the charging chip may include a 1:1 charging mode and a 2:1 charging mode. The 1:1 charging mode means that, for example, a voltage input by the external power supply is 4.5V, which will be maintained at 4.5V output through the charging chip. The charging mode of 2:1 refers to that, for example, the voltage input by the external power supply is 9V, which will be reduced to 4.5V output through the charging chip. Because the 2:1 charging mode needs to receive a large voltage input by the external power supply, the charging efficiency is higher, but the heating value is relatively large.

For example, after the charging current is less than a certain value, for example, after the charging current is less than 6A, when the electronic device is in charging and in the screen-off state, the heating of the whole machine is small. The charging chip on the large board and the charging chip on the small board may operate simultaneously to charge the battery, and the 2:1 charging mode may be adopted, for high charging efficiency. Although the 2:1 charging mode will generate some heat, since when the electronic device is in charging and in the screen-off state, the heating value of the whole machine is small, so the 2:1 charging mode will not increase too much heat of the whole machine.

When the electronic device is running the game and the brightness of the screen is less than a preset value, the screen will generated heat slightly. Therefore, the charging mode may be adjusted to the 1:1 charging mode. Although it will affect the charging efficiency, the heating value of the 1:1 charging mode is small, and the whole machine may still be controlled in a situation with small heating.

When the electronic device is running the game and the brightness of the screen is greater than the preset value, the power consumption is large. Therefore, the charging mode may be adjusted to the 2:1 charging mode to improve the charging efficiency. However, in this state, the heating value of the screen is large. In order to reduce the heating value of the whole machine, the charging chip provided on the small board may be turned off and the charging chip provided on the large board may be performing charging, so as to reduce the heating value of the whole machine.

Referring to Fig. 5, embodiments of the present disclosure provides a charging control method, which may be applied to the electronic device described in the above embodiments and implements. The control method includes the following blocks.

At block S01: at least one of an operating state of the electronic device and a running state of an application running on the electronic device is determined;
At block S02: a charging mode of each of at least two charging chips is adjusted according to at least one of the operating state of the electronic device and the running state of the application running on the electronic device, and the operation or turn-off of each charging chip is controlled.

Heating values of the mainboard of the electronic device are different due to different operating states or running states of the application. Through the above control method, the charging chip provided on the mainboard with a large heating value may be turned off more accurately, so as to reduce the heating of the whole machine and make the whole machine heat balanced.

In some embodiments, adjusting the charging mode of each of the at least two charging chips according to at least one of the operating state of the electronic device and the running state of the application running on the electronic device, and control the operation or turn-off of each charging chip may include the following situations.
(1) In a case that the operating state of the electronic device is in a screen-off state, the at least two charging chips are adjusted to a first charging mode, and the at least two charging chips are respectively controlled to operate.
   When a screen is off, charging the battery causes small heating of the whole machine. Therefore, all charging chips may be controlled to operate.
(2) In a case that the operating state of the electronic device is that a brightness of a screen is less than a preset value, and a preset application is running, the at least two charging chips are adjusted to a second charging mode, and the at least two charging chips are respectively controlled to operate.
   A charging current of the second charging mode is less than a maximum charging current of the first charging mode. That is, a heating value generated in the second charging mode will be less than a heating value generated in the first charging mode. For example, the first charging mode is 2:1 charging mode and the second charging mode is 1:1 charging mode. When the electronic device is in the operating state and the brightness of the screen is less than the preset value, the screen will heat slightly. Adjusting the charging mode to the second charging mode may appropriately reduce the heating value and maintain heat balance of the whole machine.
(3) In a case that the operating state of the electronic device is that the brightness of the screen is greater than or equal to the preset value, and the preset application is running, the at least two charging chips are adjusted to the first charging mode, a charging chip associated with the preset application is controlled to turn off, and other charging chips other than the charging chip associated with the preset application are controlled to operate.

Since the operating state of the electronic device is that the brightness of the screen is greater than or equal to the preset value, and the preset application is running which causes power consumption is large, the charging mode is adjusted to the first charging mode. However, the heating value in this state is large, so turning off the charging chip associated with the preset application and keeping other charging chips other than the charging chip associated with the preset application operating may reduce the heating value of the mainboard associated with the preset application, so as to reduce the heating value of the whole machine and maintain the heat balance of the whole machine.

The description and examples are to be considered exemplary only, and the true scope of this disclosure is disclosed by the claims.

## Claims

1. An electronic device, comprising a battery (20) and at least two charging chips (10) for charging the battery (20), wherein each of the at least two charging chips (10) is configured to operate in an independent charging mode;
each charging chip (10) comprises a first voltage sampling end (VBAT+) and a second voltage sampling end (VBAT-) for collecting voltage information of the battery (20);
each charging chip (10) is configured for independent charging according to the collected voltage information, wherein the first voltage sampling end (VBAT+) and the second voltage sampling end (VBAT-) are respectively connected to two poles of the battery (20);
the electronic device further comprises a controller (30), configured to:
determine an operating state of the electronic device; **characterized in that**
in a case that an operating state of the electronic device is in a screen-off state, adjust the at least two charging chips to a first charging mode, and respectively control the at least two charging chips to operate.

2. The electronic device according to claim 1, comprising:
a mainboard, wherein the respective charging chips (10) are provided on the main board; or
at least two mainboards, wherein the respective charging chips (10) are provided on a same mainboard in the at least two mainboards; or
at least two mainboards, wherein each mainboard is provided with at least one charging chip (10).

3. The electronic device according to claim 2, comprising two charging chips (10) and two mainboards comprising a large board and a small board, the large board is provided with one of the two charging chips (10), and the small board is provided with the other one of the two charging chips (10).

4. The electronic device according to any one of claims 1-3, comprising a controller (30), and further comprising at least two mainboards, and each mainboard is provided with at least one charging chip (10), wherein
the controller (30) is configured to obtain temperatures of the at least two mainboards respectively, and control operation or turn-off of the charging chips (30) provided on the at least two mainboards according to the temperatures of the at least two mainboards.

5. The electronic device according to any one of claims 1-4, comprising a controller (30), and further comprising a mainboard, wherein the at least two charging chips (10) are respectively provided in different areas of the mainboard,
the controller (30) is configured to obtain temperatures of the different areas of the mainboard respectively, and control operation or turn-off of the charging chips (10) provided in the different areas according to the temperatures of the different areas of the mainboard.

6. The electronic device according to any one of claims 1-5, wherein the controller (30) is configured to,
determine a running state of an application running on the electronic device;
adjust a charging mode of each of the at least two charging chips (10) according to at least one of the operating state of the electronic device and the running state of the application running on the electronic device, and control the operation or turn-off of each charging chip (10).

7. The electronic device according to any one of claims 1-6, each charging chip (10) comprises a voltage input wire (VBUS) and a voltage output wire (VOUT), the voltage input wire (VBUS) is configured for connecting with an external power supply (90), and the voltage output wire (VOUT) is configured for connecting with the battery (20);
each charging chip (10) comprises a first switch tube (Q0) and at least one charging path, each charging path is provided with a capacitor, and each charging path is formed by a plurality of switch tubes connected in series;
a first end of each charging path is connected to a first end of the first switch tube (Q0), and a second end of each charging path is grounded; the voltage input wire (VBUS) is connected to a second end of the first switch tube (Q0); the voltage output wire (VOUT) is connected between any two switch tubes of each charging path.

8. The electronic device according to claim 7 wherein the at least one charging path comprises a first charging path and a second charging path, the first charging path is provided with a first capacitor (C2), and the second charging path is provided with a second capacitor (C4);
the first charging path comprises a second switch tube (Q1), a third switch tube (Q2), a fourth switch tube (Q3) and a fifth switch tube (Q4) connected in series successively, and the second charging path comprises a sixth switch tube (Q5), a seventh switch tube (Q6), an eighth switch tube (Q7) and a ninth switch tube (Q8) connected in series successively;
a first end of the first capacitor (C2) is connected between the second switch tube (Q1) and the third switch tube (Q2), and a second end of the first capacitor (C2) is connected between the fourth switch tube (Q3) and the fifth switch tube (Q4);
a first end of the second capacitor (C4) is connected between the sixth switch tube (Q5) and the seventh switch tube (Q6), and a second end of the second capacitor (C4) is connected between the eighth switch tube (Q7) and the ninth switch tube (Q8);
the voltage output wire (VOUT) is connected between the third switch tube (Q2) and the fourth switch tube (Q3) and between the seventh switch tube (Q6) and the eighth switch tube (Q7).

9. A charging control method, applicable for an electronic device comprising a battery and at least two charging chips for charging the battery, wherein each of the at least two charging chips is configured to operate in an independent charging mode, and the control method
**characterized by** comprising:
determining (S01) at least one of an operating state of the electronic device and a running state of an application running on the electronic device; and
adjusting (S02) a charging mode of each of at least two charging chips according to at least one of the operating state of the electronic device and the running state of the application running on the electronic device, and controlling the operation or turn-off of each charging chip;
adjusting (S02) the charging mode of each of the at least two charging chips according to at least one of the operating state of the electronic device and the running state of the application running on the electronic device, and control the operation or turn-off of each charging chip comprises:
in a case that the operating state of the electronic device is in a screen-off state, adjusting the at least two charging chips to a first charging mode, and respectively controlling the at least two charging chips to operate.

10. The control method according to claim 9, wherein adjusting (S02) the charging mode of each of the at least two charging chips according to at least one of the operating state of the electronic device and the running state of the application running on the electronic device, and control the operation or turn-off of each charging chip comprises:
in a case that the operating state of the electronic device is that a brightness of a screen is less than a preset value, and a preset application is running, adjusting the at least two charging chips to a second charging mode, and respectively controlling the at least two charging chips to operate, wherein a charging current of the second charging mode is less than a maximum charging current of the first charging mode;
in a case that the operating state of the electronic device is that the brightness of the screen is not less than the preset value, and the preset application is running, adjusting the at least two charging chips to the first charging mode, control a charging chip associated with the preset application to turn off, and other charging chips other than the charging chip associated with the preset application to operate.

11. The control method according to claim 9 or 10, comprising:
collecting voltage information of the battery by a first voltage sampling end and a second voltage sampling end of each charging chip;
performing, by each charging chip, independent charging, according to the collected voltage information, wherein the first voltage sampling end and the second voltage sampling end are respectively connected to two poles of the battery.

12. The control method according to claim 11, wherein the electronic device comprises at least two mainboards, each mainboard is provided with at least one charging chip, and the method comprises:
obtaining temperatures of the at least two mainboards respectively;
controlling operation or turn-off of the charging chips provided on the at least two mainboards according to the temperatures of the at least two mainboards.

13. The control method according to claim 11, wherein the electronic device comprises a mainboard, the at least two charging chips are respectively provided in different areas of the mainboard, and the method comprising:
obtaining temperatures of the different areas of the mainboard respectively;
controlling operation or turn-off of the charging chips provided in the different areas according to the temperatures of the different areas of the mainboard.

## Patentansprüche

1. Elektronische Vorrichtung, umfassend eine Batterie (20) und mindestens zwei Ladechips (10) zum Laden der Batterie (20), wobei jeder der mindestens zwei Ladechips (10) dazu konfiguriert ist, in einem unabhängigen Lademodus zu arbeiten;
jeder Ladechip (10) umfasst einen ersten Spannungsabtastanschluss (VBAT+) und einen zweiten Spannungsabtastanschluss (VBAT-) zum Erfassen von Spannungsinformationen der Batterie (20);
jeder Ladechip (10) ist zum unabhängigen Laden gemäß den erfassten Spannungsinformationen konfiguriert, wobei der erste Spannungsabtastanschluss (VBAT+) und der zweite Spannungsabtastanschluss (VBAT-) jeweils mit zwei Polen der Batterie (20) verbunden sind;
die elektronische Vorrichtung umfasst ferner einen Controller (30), der dazu konfiguriert ist:
einen Betriebszustand der elektronischen Vorrichtung zu bestimmen; **dadurch gekennzeichnet, dass**
in einem Fall, in dem ein Betriebszustand der elektronischen Vorrichtung ein Bildschirm-Aus-Zustand ist, die mindestens zwei Ladechips auf einen ersten Lademodus eingestellt und die mindestens zwei Ladechips jeweils zum Betrieb gesteuert werden.

2. Elektronische Vorrichtung gemäß Anspruch 1, umfassend:
eine Hauptplatine, wobei die jeweiligen Ladechips (10) auf der Hauptplatine vorgesehen sind; oder
mindestens zwei Hauptplatinen, wobei die jeweiligen Ladechips (10) auf einer gleichen Hauptplatine der mindestens zwei Hauptplatinen vorgesehen sind; oder
mindestens zwei Hauptplatinen, wobei jede Hauptplatine mit mindestens einem Ladechip (10) versehen ist.

3. Elektronische Vorrichtung gemäß Anspruch 2, umfassend zwei Ladechips (10) und zwei Hauptplatinen, die eine große Platine und eine kleine Platine umfassen, wobei die große Platine mit einem der beiden Ladechips (10) versehen ist und die kleine Platine mit dem anderen der beiden Ladechips (10) versehen ist.

4. Elektronische Vorrichtung gemäß einem der Ansprüche 1 bis 3, umfassend einen Controller (30), und ferner umfassend mindestens zwei Hauptplatinen, wobei jede Hauptplatine mit mindestens einem Ladechip (10) versehen ist, wobei
der Controller (30) dazu konfiguriert ist, Temperaturen der mindestens zwei Hauptplatinen jeweils zu erhalten und einen Betrieb oder ein Abschalten der auf den mindestens zwei Hauptplatinen vorgesehenen Ladechips (30) gemäß den Temperaturen der mindestens zwei Hauptplatinen zu steuern.

5. Elektronische Vorrichtung gemäß einem der Ansprüche 1 bis 4, umfassend einen Controller (30), und ferner umfassend eine Hauptplatine, wobei die mindestens zwei Ladechips (10) jeweils in verschiedenen Bereichen der Hauptplatine vorgesehen sind,
wobei der Controller (30) dazu konfiguriert ist, Temperaturen der verschiedenen Bereiche der Hauptplatine jeweils zu erhalten und einen Betrieb oder ein Abschalten der in den verschiedenen Bereichen vorgesehenen Ladechips (10) gemäß den Temperaturen der verschiedenen Bereiche der Hauptplatine zu steuern.

6. Elektronische Vorrichtung gemäß einem der Ansprüche 1 bis 5, wobei der Controller (30) dazu konfiguriert ist,
einen Ausführungszustand einer auf der elektronischen Vorrichtung ausgeführten Anwendung zu bestimmen;
einen Lademodus jedes der mindestens zwei Ladechips (10) gemäß mindestens einem aus dem Betriebszustand der elektronischen Vorrichtung und dem Ausführungszustand der auf der elektronischen Vorrichtung ausgeführten Anwendung einzustellen und einen Betrieb oder ein Abschalten jedes Ladechips (10) zu steuern.

7. Elektronische Vorrichtung gemäß einem der Ansprüche 1 bis 6, wobei jeder Ladechip (10) eine Spannungseingangsleitung (VBUS) und eine Spannungsausgangsleitung (VOUT) umfasst, wobei die Spannungseingangsleitung (VBUS) zum Verbinden mit einer externen Stromversorgung (90) konfiguriert ist und die Spannungsausgangsleitung (VOUT) zum Verbinden mit der Batterie (20) konfiguriert ist;
jeder Ladechip (10) umfasst eine erste Schaltröhre (Q0) und mindestens einen Ladepfad, wobei jeder Ladepfad mit einem Kondensator versehen ist und jeder Ladepfad durch mehrere in Reihe verbundene Schaltröhren gebildet ist;
wobei ein erstes Ende jedes Ladepfads mit einem ersten Ende der ersten Schaltröhre (Q0) verbunden ist und ein zweites Ende jedes Ladepfads geerdet ist; wobei die Spannungseingangsleitung (VBUS) mit einem zweiten Ende der ersten Schaltröhre (Q0) verbunden ist; und wobei die Spannungsausgangsleitung (VOUT) zwischen beliebigen zwei Schaltröhren jedes Ladepfads verbunden ist.

8. Elektronische Vorrichtung gemäß Anspruch 7, wobei der mindestens eine Ladepfad einen ersten Ladepfad und einen zweiten Ladepfad umfasst, wobei der erste Ladepfad mit einem ersten Kondensator (C2) versehen ist und der zweite Ladepfad mit einem zweiten Kondensator (C4) versehen ist;
wobei der erste Ladepfad eine zweite Schaltröhre (Q1), eine dritte Schaltröhre (Q2), eine vierte Schaltröhre (Q3) und eine fünfte Schaltröhre (Q4) umfasst, die nacheinander in Reihe verbunden sind, und der zweite Ladepfad eine sechste Schaltröhre (Q5), eine siebte Schaltröhre (Q6), eine achte Schaltröhre (Q7) und eine neunte Schaltröhre (Q8) umfasst, die nacheinander in Reihe verbunden sind;
wobei ein erstes Ende des ersten Kondensators (C2) zwischen der zweiten Schaltröhre (Q1) und der dritten Schaltröhre (Q2) verbunden ist und ein zweites Ende des ersten Kondensators (C2) zwischen der vierten Schaltröhre (Q3) und der fünften Schaltröhre (Q4) verbunden ist;
wobei ein erstes Ende des zweiten Kondensators (C4) zwischen der sechsten Schaltröhre (Q5) und der siebten Schaltröhre (Q6) verbunden ist und ein zweites Ende des zweiten Kondensators (C4) zwischen der achten Schaltröhre (Q7) und der neunten Schaltröhre (Q8) verbunden ist;
wobei die Spannungsausgangsleitung (VOUT) zwischen der dritten Schaltröhre (Q2) und der vierten Schaltröhre (Q3) sowie zwischen der siebten Schaltröhre (Q6) und der achten Schaltröhre (Q7) verbunden ist.

9. Ladesteuerverfahren, anwendbar auf eine elektronische Vorrichtung, die eine Batterie und mindestens zwei Ladechips zum Laden der Batterie umfasst, wobei jeder der mindestens zwei Ladechips dazu konfiguriert ist, in einem unabhängigen Lademodus zu arbeiten, wobei das Steuerverfahren
**dadurch gekennzeichnet ist, dass** es Folgendes umfasst:
Bestimmen (S01) von mindestens einem aus einem Betriebszustand der elektronischen Vorrichtung und einem Ausführungszustand einer auf der elektronischen Vorrichtung ausgeführten Anwendung; und
Einstellen (S02) eines Lademodus jedes von mindestens zwei Ladechips gemäß mindestens einem aus dem Betriebszustand der elektronischen Vorrichtung und dem Ausführungszustand der auf der elektronischen Vorrichtung ausgeführten Anwendung, und Steuern eines Betriebs oder eines Abschaltens jedes Ladechips;
wobei das Einstellen (S02) des Lademodus jedes der mindestens zwei Ladechips gemäß mindestens einem aus dem Betriebszustand der elektronischen Vorrichtung und dem Ausführungszustand der auf der elektronischen Vorrichtung ausgeführten Anwendung und das Steuern des Betriebs oder des Abschaltens jedes Ladechips Folgendes umfasst:
in einem Fall, in dem der Betriebszustand der elektronischen Vorrichtung ein Bildschirm-Aus-Zustand ist, Einstellen der mindestens zwei Ladechips auf einen ersten Lademodus und jeweiliges Steuern der mindestens zwei Ladechips zum Betrieb.

10. Steuerverfahren gemäß Anspruch 9, wobei das Einstellen (S02) des Lademodus jedes der mindestens zwei Ladechips gemäß mindestens einem aus dem Betriebszustand der elektronischen Vorrichtung und dem Ausführungszustand der auf der elektronischen Vorrichtung ausgeführten Anwendung und das Steuern des Betriebs oder des Abschaltens jedes Ladechips Folgendes umfasst:
in einem Fall, in dem der Betriebszustand der elektronischen Vorrichtung dahingehend besteht, dass eine Helligkeit eines Bildschirms kleiner als ein voreingestellter Wert ist und eine voreingestellte Anwendung ausgeführt wird, Einstellen der mindestens zwei Ladechips auf einen zweiten Lademodus und jeweiliges Steuern eines Betriebs der mindestens zwei Ladechips, wobei ein Ladestrom des zweiten Lademodus kleiner als ein maximaler Ladestrom des ersten Lademodus ist;
in einem Fall, in dem der Betriebszustand der elektronischen Vorrichtung dahingehend besteht, dass die Helligkeit des Bildschirms nicht kleiner als der voreingestellte Wert ist und die voreingestellte Anwendung ausgeführt wird, Einstellen der mindestens zwei Ladechips auf den ersten Lademodus, Steuern eines Abschaltens eines Ladechips, der der voreingestellten Anwendung zugeordnet ist, und Steuern eines Betriebs anderer Ladechips als des der voreingestellten Anwendung zugeordneten Ladechips.

11. Steuerverfahren gemäß Anspruch 9 oder 10, umfassend:
Erfassen von Spannungsinformationen der Batterie durch einen ersten Spannungsabtastanschluss und einen zweiten Spannungsabtastanschluss jedes Ladechips;
Ausführen eines unabhängigen Ladens durch jeden Ladechip gemäß den erfassten Spannungsinformationen, wobei der erste Spannungsabtastanschluss und der zweite Spannungsabtastanschluss jeweils mit zwei Polen der Batterie verbunden sind.

12. Steuerverfahren gemäß Anspruch 11, wobei die elektronische Vorrichtung mindestens zwei Hauptplatinen umfasst, jede Hauptplatine mit mindestens einem Ladechip versehen ist, und das Verfahren Folgendes umfasst:
jeweiliges Erhalten von Temperaturen der mindestens zwei Hauptplatinen;
Steuern eines Betriebs oder eines Abschaltens der auf den mindestens zwei Hauptplatinen vorgesehenen Ladechips gemäß den Temperaturen der mindestens zwei Hauptplatinen.

13. Steuerverfahren gemäß Anspruch 11, wobei die elektronische Vorrichtung eine Hauptplatine umfasst, die mindestens zwei Ladechips jeweils in verschiedenen Bereichen der Hauptplatine vorgesehen sind, und das Verfahren Folgendes umfasst:
jeweiliges Erhalten von Temperaturen der verschiedenen Bereiche der Hauptplatine;
Steuern eines Betriebs oder eines Abschaltens der in den verschiedenen Bereichen vorgesehenen Ladechips gemäß den Temperaturen der verschiedenen Bereiche der Hauptplatine.

## Revendications

1. Dispositif électronique, comprenant une batterie (20) et au moins deux puces de charge (10) pour charger la batterie (20), dans lequel chacune des au moins deux puces de charge (10) est configurée pour fonctionner dans un mode de charge indépendant ;
chaque puce de charge (10) comprend une première borne d'échantillonnage de tension (VBAT+) et une deuxième borne d'échantillonnage de tension (VBAT-) pour recueillir des informations de tension de la batterie (20) ;
chaque puce de charge (10) est configurée pour une charge indépendante selon les informations de tension recueillies, dans lequel la première borne d'échantillonnage de tension (VBAT+) et la deuxième borne d'échantillonnage de tension (VBAT-) sont respectivement reliées à deux pôles de la batterie (20) ;
le dispositif électronique comprend en outre un contrôleur (30) configuré pour :
déterminer un état de fonctionnement du dispositif électronique ; **caractérisé en ce que**
dans un cas où un état de fonctionnement du dispositif électronique est un état d'écran éteint, ajuster les au moins deux puces de charge à un premier mode de charge, et commander respectivement le fonctionnement des au moins deux puces de charge.

2. Dispositif électronique selon la revendication 1, comprenant :
une carte principale, dans laquelle les puces de charge respectives (10) sont prévues sur la carte principale ; ou
au moins deux cartes principales, dans lesquelles les puces de charge respectives (10) sont prévues sur une même carte principale parmi les au moins deux cartes principales ; ou
au moins deux cartes principales, dans lesquelles chacune des cartes principales est pourvue d'au moins une puce de charge (10).

3. Dispositif électronique selon la revendication 2, comprenant deux puces de charge (10) et deux cartes principales comprenant une grande carte et une petite carte, la grande carte étant pourvue de l'une des deux puces de charge (10), et la petite carte étant pourvue de l'autre des deux puces de charge (10).

4. Dispositif électronique selon l'une quelconque des revendications 1 à 3, comprenant un contrôleur (30), et comprenant en outre au moins deux cartes principales, chaque carte principale étant pourvue d'au moins une puce de charge (10), dans lequel
le contrôleur (30) est configuré pour obtenir respectivement des températures des au moins deux cartes principales, et commander le fonctionnement ou l'arrêt des puces de charge (30) prévues sur les au moins deux cartes principales selon les températures des au moins deux cartes principales.

5. Dispositif électronique selon l'une quelconque des revendications 1 à 4, comprenant un contrôleur (30), et comprenant en outre une carte principale, dans lequel les au moins deux puces de charge (10) sont respectivement prévues dans différentes zones de la carte principale,
le contrôleur (30) est configuré pour obtenir respectivement des températures des différentes zones de la carte principale, et commander le fonctionnement ou l'arrêt des puces de charge (10) prévues dans les différentes zones selon les températures des différentes zones de la carte principale.

6. Dispositif électronique selon l'une quelconque des revendications 1 à 5, dans lequel le contrôleur (30) est configuré pour,
déterminer un état d'exécution d'une application en cours d'exécution sur le dispositif électronique ;
ajuster un mode de charge de chacune des au moins deux puces de charge (10) selon au moins l'un de l'état de fonctionnement du dispositif électronique et de l'état d'exécution de l'application en cours d'exécution sur le dispositif électronique, et commander le fonctionnement ou l'arrêt de chaque puce de charge (10).

7. Dispositif électronique selon l'une quelconque des revendications 1 à 6, chaque puce de charge (10) comprenant un fil d'entrée de tension (VBUS) et un fil de sortie de tension (VOUT), le fil d'entrée de tension (VBUS) étant configuré pour être relié à une alimentation électrique externe (90), et le fil de sortie de tension (VOUT) étant configuré pour être relié à la batterie (20) ;
chaque puce de charge (10) comprend un premier transistor de commutation (Q0) et au moins un chemin de charge, chaque chemin de charge étant pourvu d'un condensateur, et chaque chemin de charge étant formé par une pluralité de transistors de commutation reliés en série ;
une première extrémité de chaque chemin de charge est reliée à une première extrémité du premier transistor de commutation (Q0), et une deuxième extrémité de chaque chemin de charge est mise à la masse ; le fil d'entrée de tension (VBUS) est relié à une deuxième extrémité du premier transistor de commutation (Q0) ; le fil de sortie de tension (VOUT) est relié entre deux transistors de commutation quelconques de chaque chemin de charge.

8. Dispositif électronique selon la revendication 7, dans lequel le au moins un chemin de charge comprend un premier chemin de charge et un deuxième chemin de charge, le premier chemin de charge étant pourvu d'un premier condensateur (C2), et le deuxième chemin de charge étant pourvu d'un deuxième condensateur (C4) ;
le premier chemin de charge comprend un deuxième transistor de commutation (Q1), un troisième transistor de commutation (Q2), un quatrième transistor de commutation (Q3) et un cinquième transistor de commutation (Q4) reliés en série successivement, et le deuxième chemin de charge comprend un sixième transistor de commutation (Q5), un septième transistor de commutation (Q6), un huitième transistor de commutation (Q7) et un neuvième transistor de commutation (Q8) reliés en série successivement ;
une première extrémité du premier condensateur (C2) est reliée entre le deuxième transistor de commutation (Q1) et le troisième transistor de commutation (Q2), et une deuxième extrémité du premier condensateur (C2) est reliée entre le quatrième transistor de commutation (Q3) et le cinquième transistor de commutation (Q4) ;
une première extrémité du deuxième condensateur (C4) est reliée entre le sixième transistor de commutation (Q5) et le septième transistor de commutation (Q6), et une deuxième extrémité du deuxième condensateur (C4) est reliée entre le huitième transistor de commutation (Q7) et le neuvième transistor de commutation (Q8) ;
le fil de sortie de tension (VOUT) est relié entre le troisième transistor de commutation (Q2) et le quatrième transistor de commutation (Q3) et entre le septième transistor de commutation (Q6) et le huitième transistor de commutation (Q7).

9. Procédé de commande de charge, applicable à un dispositif électronique comprenant une batterie et au moins deux puces de charge pour charger la batterie, dans lequel chacune des au moins deux puces de charge est configurée pour fonctionner dans un mode de charge indépendant, le procédé de commande
étant **caractérisé en ce qu'**il
comprend :
la détermination (S01) d'au moins l'un d'un état de fonctionnement du dispositif électronique et d'un état d'exécution d'une application en cours d'exécution sur le dispositif électronique ; et
l'ajustement (S02) d'un mode de charge de chacune d'au moins deux puces de charge selon au moins l'un de l'état de fonctionnement du dispositif électronique et de l'état d'exécution de l'application en cours d'exécution sur le dispositif électronique, et la commande du fonctionnement ou de l'arrêt de chaque puce de charge ;
l'ajustement (S02) du mode de charge de chacune des au moins deux puces de charge selon au moins l'un de l'état de fonctionnement du dispositif électronique et de l'état d'exécution de l'application en cours d'exécution sur le dispositif électronique, et la commande du fonctionnement ou de l'arrêt de chaque puce de charge comprenant :
dans un cas où l'état de fonctionnement du dispositif électronique est un état d'écran éteint, l'ajustement des au moins deux puces de charge à un premier mode de charge, et la commande respective du fonctionnement des au moins deux puces de charge.

10. Procédé de commande selon la revendication 9, dans lequel l'ajustement (S02) du mode de charge de chacune des au moins deux puces de charge selon au moins l'un de l'état de fonctionnement du dispositif électronique et de l'état d'exécution de l'application en cours d'exécution sur le dispositif électronique, et la commande du fonctionnement ou de l'arrêt de chaque puce de charge comprennent :
dans un cas où l'état de fonctionnement du dispositif électronique est tel qu'une luminosité d'un écran est inférieure à une valeur prédéfinie, et qu'une application prédéfinie est en cours d'exécution, l'ajustement des au moins deux puces de charge à un deuxième mode de charge, et la commande respective du fonctionnement des au moins deux puces de charge, dans lequel un courant de charge du deuxième mode de charge est inférieur à un courant de charge maximal du premier mode de charge ;
dans un cas où l'état de fonctionnement du dispositif électronique est tel que la luminosité de l'écran n'est pas inférieure à la valeur prédéfinie, et que l'application prédéfinie est en cours d'exécution, l'ajustement des au moins deux puces de charge au premier mode de charge, la commande de l'arrêt d'une puce de charge associée à l'application prédéfinie, et la commande du fonctionnement d'autres puces de charge que la puce de charge associée à l'application prédéfinie.

11. Procédé de commande selon la revendication 9 ou 10, comprenant :
le recueil d'informations de tension de la batterie par une première borne d'échantillonnage de tension et une deuxième borne d'échantillonnage de tension de chaque puce de charge ;
la mise en œuvre, par chaque puce de charge, d'une charge indépendante selon les informations de tension recueillies, dans lequel la première borne d'échantillonnage de tension et la deuxième borne d'échantillonnage de tension sont respectivement reliées à deux pôles de la batterie.

12. Procédé de commande selon la revendication 11, dans lequel le dispositif électronique comprend au moins deux cartes principales, chaque carte principale étant pourvue d'au moins une puce de charge, et le procédé comprend :
l'obtention respective de températures des au moins deux cartes principales ;
la commande du fonctionnement ou de l'arrêt des puces de charge prévues sur les au moins deux cartes principales selon les températures des au moins deux cartes principales.

13. Procédé de commande selon la revendication 11, dans lequel le dispositif électronique comprend une carte principale, les au moins deux puces de charge étant respectivement prévues dans différentes zones de la carte principale, et le procédé comprenant :
l'obtention respective de températures des différentes zones de la carte principale ;
la commande du fonctionnement ou de l'arrêt des puces de charge prévues dans les différentes zones selon les températures des différentes zones de la carte principale.
